# EUROPEAN PATENT SPECIFICATION

(11) **EP 1 141 669 B1**
(45) Date of publication and mention of the grant of the patent: **28.02.2007**
(21) Application number: 98959258.9
(22) Date of filing: 04.12.1998
(51) Int. Cl.: G01J 5/20

(54) **INFRARED BOLOMETER AND METHOD FOR MANUFACTURING SAME**
INFRAROTEMPFINDLICHES BOLOMETER UND VERFAHREN ZU DESSEN HERSTELLUNG
BOLOMETRE A INFRAROUGES ET PROCEDE DE FABRICATION ASSOCIE

(43) Date of publication of application: 10.10.2001
(73) Proprietor: Daewoo Electronics Corporation, Seoul (KR)
(72) Inventor: YONG, Yoon Joong Video Research Center, Jung-gu Seoul 100-095 (KR)
(74) Representative: Turi, Michael
(86) International application number: PCT/KR1998/000405
(87) International publication number: WO 2000/034751

(56) References cited:
- US-A- 5 288 649
- US-A- 5 572 029

## Description

### TECHNICAL FIELD OF THE INVENTION

The present invention relates to an infrared bolometer; and, more particularly, to a three-level infrared bolometer and a manufacturing method thereof.

### BACKGROUND ART

Bolometers are energy detectors based upon a change in the resistance of materials (called bolometer elements) that are exposed to a radiation flux. The bolometer elements have been made from metals or semiconductors. In metals, the resistance change is essentially due to variations in the carrier mobility, which typically decreases with temperature. Greater sensitivity can be obtained in high-resistivity semiconductor bolometer elements in which the free-carrier density is an exponential function of temperature, but thin film fabrication of semiconductor for bolometers is a difficult problem.

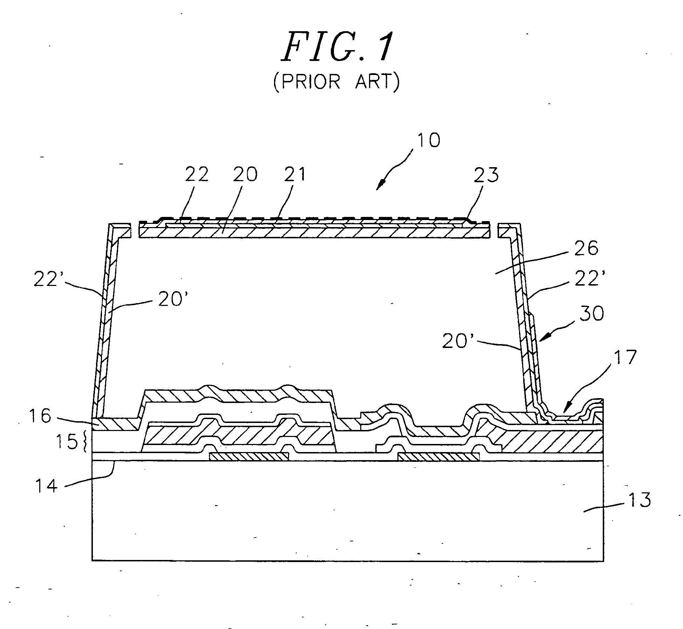

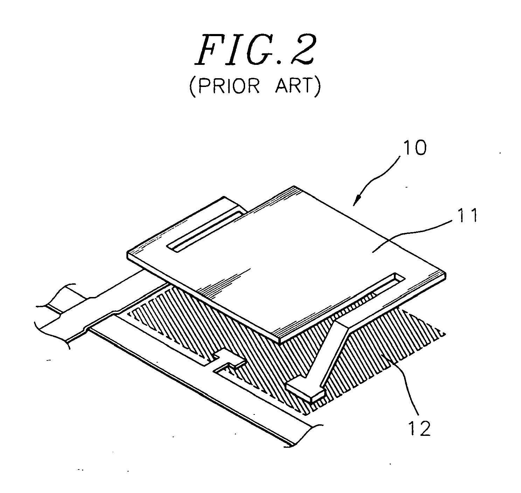

Figs. 1 and 2 are a cross sectional and a perspective views illustrating a two-level bolometer 10, disclosed in U.S. Patent No. 5,300,915 entitled "THERMAL SENSOR", the bolometer 10 including an elevated microbridge detector level 11 and a lower level 12. The lower level 12 has a flat surfaced semiconductor substrate 13, such as a single crystal silicon substrate. The surface 14 of the silicon substrate 13 has fabricated thereon-several components of an integrated circuit 15 including diodes, x and y bus lines, connections, and contact pads at the ends of the x and y bus lines, the fabrication following conventional silicon IC technology. The integrated circuit 15 is coated with a protective layer of silicon nitride 16. The valley strip 17 is the area not covered by the elevated detector.

The elevated detector level 11 includes a silicon nitride layer 20, a serpentine metallic resistive path 21, a silicon nitride layer 22 over the layers 20 and 21, and an infrared absorber coating 23 (hereinafter, "IR absorber coating") over the silicon nitride layer 22. Downwardly extending silicon nitride layers 20' and 22' deposited at the same time during the fabrication make up the four sloping support legs for the elevated detector level 11. The number of support legs may be greater or less than four. The cavity 26 between the two levels is ambient atmosphere. During the fabrication process, however, the cavity 26 was originally filled with a previously deposited layer of easily dissolvable glass or other dissolvable material until the layers 20, 20' and 22, 22' were deposited. Subsequently in the process the glass was dissolved out to leave the cavity.

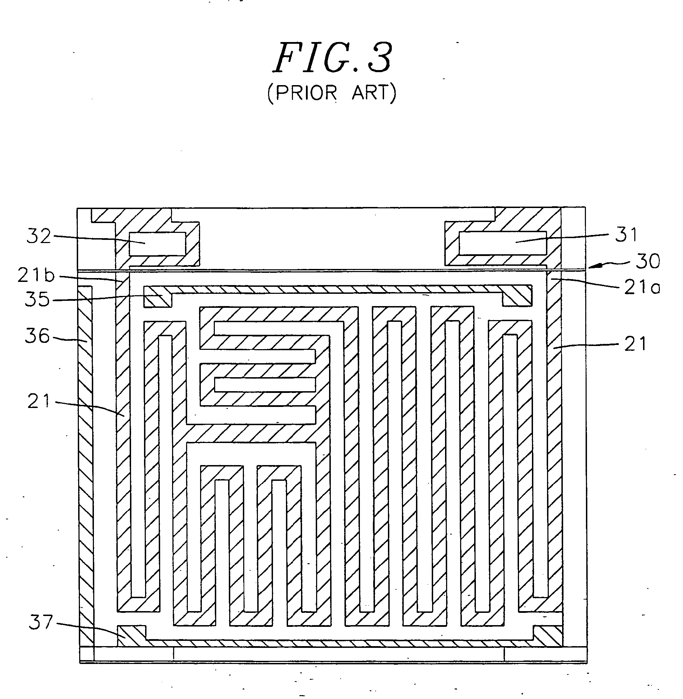

In Fig. 3, there is a top view depicting the elevated detector level 11 shown in Fig. 1. This drawing is made as though the overlying absorber coating 23 and the upper silicon nitride layer 22 are transparent so the serpentine resistive layer path 21 can be shown. The ends 21a, 21b of the resistive path 21 are continued down the slope area 30. to make electrical contact with pads 31 and 32 on the lower level 12. Fig. 3 shows the nitride window cuts 35, 36 and 37 which are opened through the silicon nitride layers 20 and 22 to provide access to the phosphor-glass beneath for dissolving it from beneath the detector plane. The nitride window cuts 35, 36, 37 to provide this access are narrow and are shared with adjacent pixels on the sides, thus maximizing the area available to the detector and thus maximizing the fill-factor. The four supporting bridges may be short or as long as necessary to provide adequate support and thermal isolation.

One of the shortcomings of the above described bolometer is its less than optimum fill factor resulting from the presence of the bridges on same level as the elevated microbridge detector level, which, in turn, reduces the total area for IR absorbing, i.e., the fill factor.

### DISCLOSURE OF THE INVENTION

It is, therefore, an object of the present invention to provide a three-level infrared bolometer having an increased fill factor and an improved absorbance and a manufacturing method thereof.

In accordance with one aspect of the present invention, there is provided a three-level infrared bolometer, the bolometer comprising: an active matrix level, the active matrix level including a substrate and at least a pair of connecting terminals, wherein the pair of connecting terminals are formed on top of the substrate, a support level provided with at least a pair of bridges, each of the bridges including an conduction line, one end of the conduction line being electrically connected to the respective-connecting terminal, an absorption level, the absorption level including an absorber, a bolometer element surrounded by the absorber, and an infrared absorber coating formed on top of the absorber and having a rough surface, and at least a pair of posts, each of the posts being placed between the absorption level and the support level and including an electrical conduit surrounded by an insulating material, each end of the bolometer element of the absorption level being electrically connected to the respective connecting terminal through the respective electrical conduit and the respective conduction line.

In accordance with another aspect of the present invention, there is provided a method for the manufacture of a three-level- infrared bolometer, the method comprising the step of preparing an active matrix level including a substrate and a pair of connecting terminals, forming a first sacrificial layer including a pair of cavities on top of the active matrix level, forming a support level including a pair of bridges, wherein each of the bridges includes a conduction line formed thereon, forming a second sacrificial layer including a pair of holes on top of the bridges and the first sacrificial layer, forming an absorption level including a bolometer element surrounded by an absorber, depositing an infrared absorber coating on top of the absorber, etching the infrared absorber coating so as to have a rough top surface, and removing the second and the first sacrificial layers, respectively, to thereby form said three-level infrared bolometer.

### BRIEF DESCRIPTION OF THE DRAWINGS

The above and other objects and features of the present invention will become apparent from the following description of the preferred embodiments given in conjunction with the accompanying drawings, wherein:
Fig: 1 present a schematic cross sectional view illustrating a two-level microbridge bolometer previous disclosed;
Fig. 2 shows a perspective view setting forth a two-level microbridge bolometer shown in Fig. 1;
Fig. 3 produces a top view depicting an elevated detector level in Fig. 1;
Fig. 4 shows a perspective view setting forth a three-level infrared bolometer in accordance with the present invention;
Fig. 5 presents a schematic cross section view depicting the three-level infrared bolometer taken along I-I in Fig. 4; and
Figs. 6A to 6M provides schematic cross sectional views illustrating a method for manufacturing the three-level infrared bolometer in Fig. 5.

### MODES OF CARRYING OUT THE INVENTION

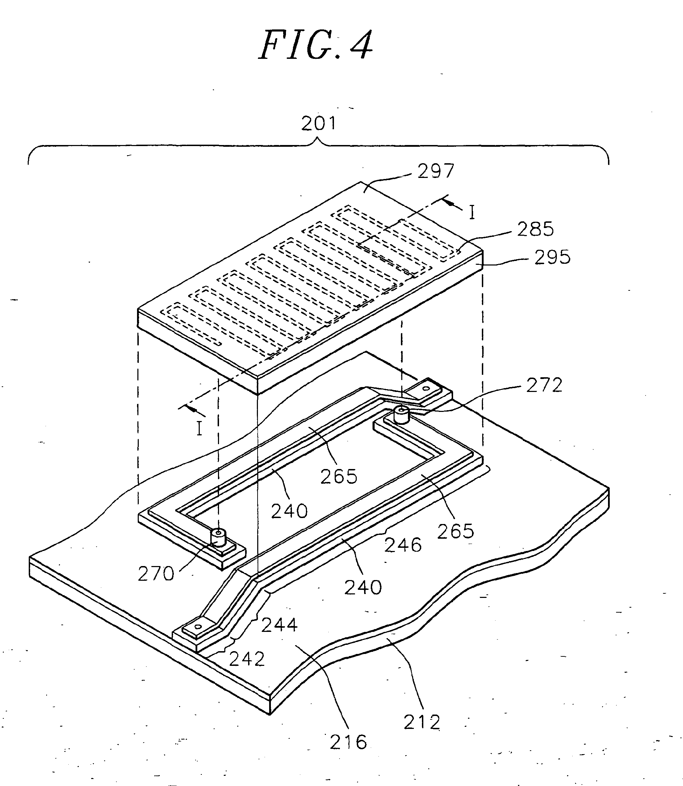

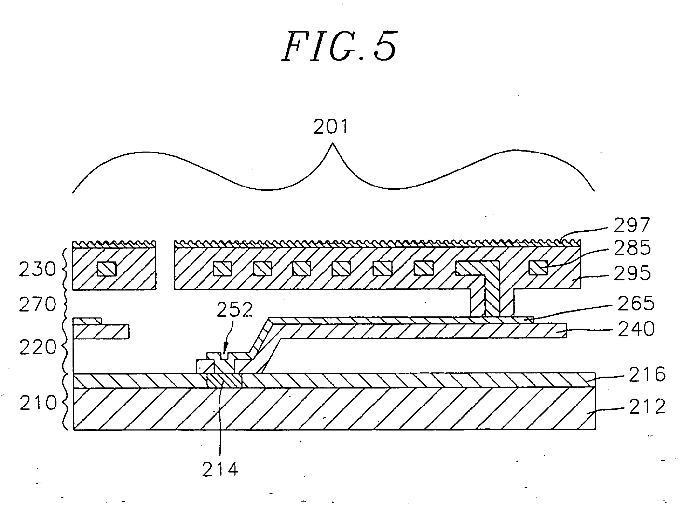

There are provided in Figs. 4 and 5 a perspective view illustrating a three-level infrared bolometer 201 in accordance with the present invention and a schematic cross sectional view taken along I-I in Fig. 4, respectively. It should be noted that like parts appearing in Figs. 4 and 5 are represented by like reference numerals.

The inventive bolometer 201 shown in Figs. 4 and 5 comprises an active matrix level 210, a support level 220, at least a pair of posts 270 and an absorption level 230.

The active matrix level 210 has a substrate 212 including an integrated circuit (not shown), a pair of connecting terminals 214 and a protective layer 216. Each of the connecting terminals 214 made of a metal is located on top of the substrate 212. The protective layer 216 made of, e.g., silicon nitride (SiNₓ) covers the substrate 212. The pair of connecting terminals 214 are electrically connected to the integrated circuit.

The support level 220 includes a pair of bridges 240 made of silicon nitride (SiNₓ), each of the bridges 240 having a conduction line 265 formed on top thereof. Each of the bridges 240 is provided with an anchor portion 242, a leg portion 244 and an elevated portion 246, the anchor portion 242 including a via hole 252 through which one end of the conduction line 265 is electrically connected to the connecting terminal 214 and the leg portion 244 supporting the elevated portion 246.

The absorption level 230 is provided with an absorber 295 made of a heat absorbing material, e.g., silicon oxide (SiO₂), a serpentine bolometer element 285 made of, e.g., titanium (Ti) and surrounded by the absorber 295, and an IR absorber coating 297 formed on top of the absorber 295.

Each of the posts 270 is placed between the absorption level 230 and the support level 220. Each of the post 270 includes an electrical conduit 272 made of a metal, e.g., titanium (Ti) and surrounded by an insulating material. Top end of the electrical conduit 272 is electrically connected to one end of the serpentine bolometer element 285 and bottom end thereof is electrically connected to the conduction line 265 on the bridge 240, in such a way that both ends of the serpentine bolometer element 285 in the absorption level 230 is electrically connected to the integrated circuit of the active matrix level 210 through the electrical conduits 272, the conduction lines 265 and the connecting terminals 214.

When the infrared energy is absorbed, the resistivity of the serpentine bolometer element 285 is changed, wherein the changed resistivity causes a current and a voltage to vary. The varied current or voltage is amplified by the integrated circuit in such a way that the amplified current or voltage is read out by a detective circuit (not shown).

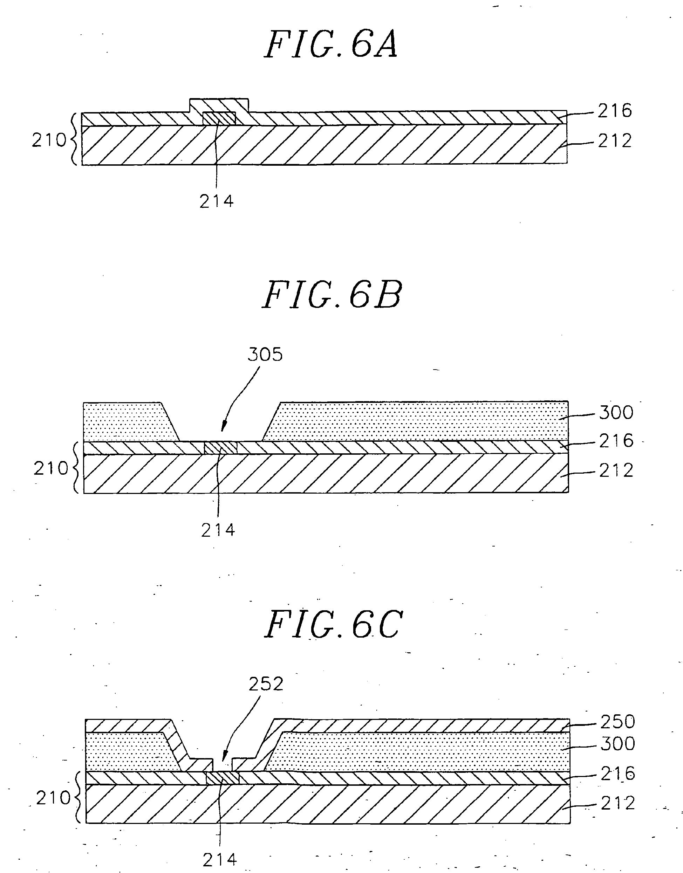

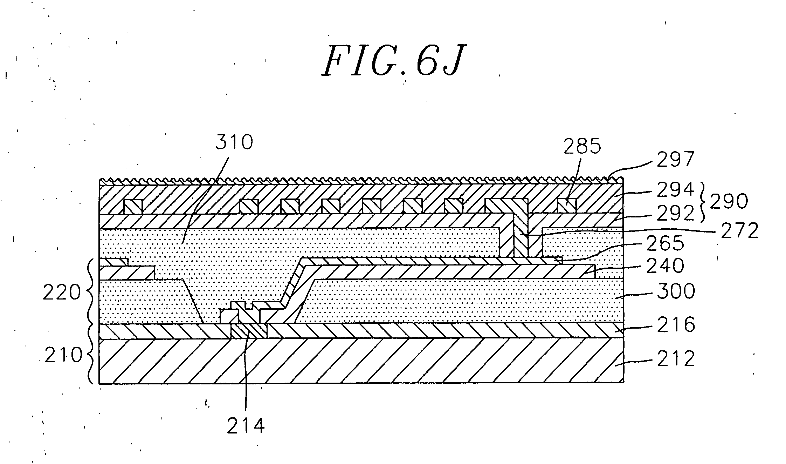

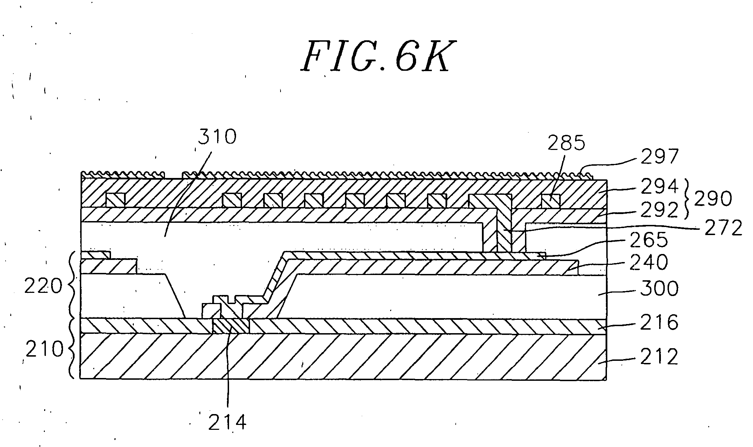

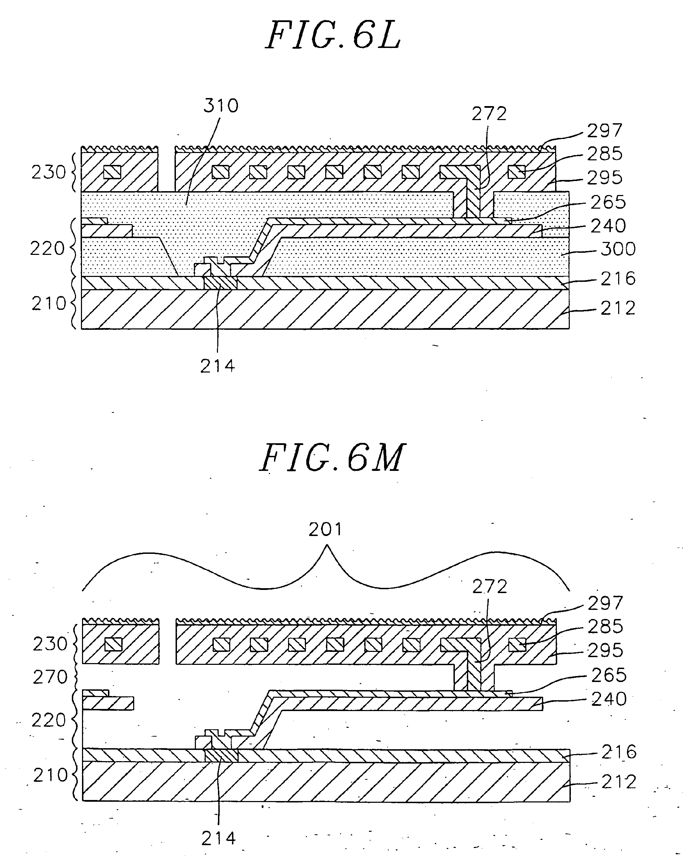

The method for manufacturing the inventive infrared bolometer will now be described with reference to Figs. 6A to 6M.

The process for the manufacture of the bolometer 201 begins with the preparation of the substrate 212 including the integrate circuit and the pair of connecting terminals 214.

Subsequently, the protective layer 216 made of, e.g., silicon nitride (Si₃N₄), is deposited on top of the substrate 212 by using a plasma enhanced chemical vapor deposition (PECVD) method to thereby form an active matrix level 210, as shown in Fig. 6A.

In a next step, a first sacrificial material (not shown) comprising, e.g., poly-Si, is deposited on top of the protective layer 216 by using a low pressure chemical vapor deposition (LPCVD) method so as to have a flat top surface. The first sacrificial material is then removed, selectively, to form a first sacrificial layer 300 including a pair of cavities 305 by using an etching method, as shown in Fig. 6B.

Next, a support layer 250 made of, e.g., silicon nitride (SiNₓ), is deposited on top of the first sacrificial layer 300 including the cavities 305 by using the PECVD method.

Subsequently, a pair of via holes 252 are formed in the support layer 250 to expose the connecting terminals 214, as shown in Fig. 6C.

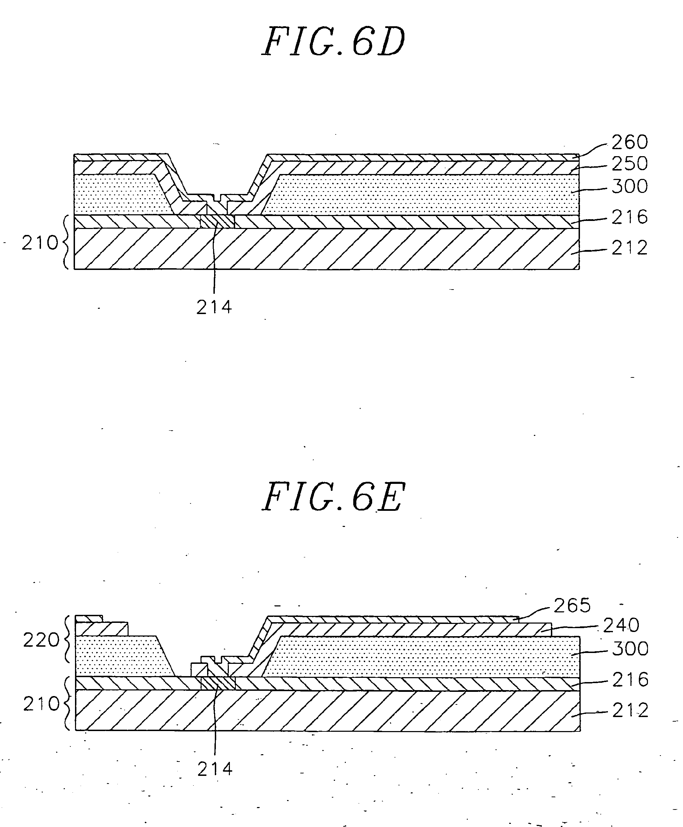

Thereafter, a conductive layer 260 made of a metal, e.g., Ti, is deposited on top of the support layer 250 including the via holes 252 by using a sputtering method, wherein the via holes 252 are filled with the metal constituting the conductive layer 260 thereby electrically connecting the conductive layer 260 to the connecting terminals 214, as shown in Fig. 6D.

Then, the conductive layer 260 and the support layer 250 are patterned into the pair of conduction lines 265 and the pair of bridges 240 by using a metal etching method and a nitride etching method, respectively, to thereby form the support level 220, as shown in Fig. 6E.

In a subsequent step, a second sacrificial material (not shown) comprising, e.g., a poly-Si, is deposited on top of the bridges 240 and the first sacrificial layer 300 by using the LPCVD method so as to have a flat top surface. The second sacrificial material is then removed, selectively, to form a second sacrificial layer 310 including a pair of holes 315 by using the etching method, as shown in Fig. 6F.

In a following step, the first absorption material 292, e.g., SiO₂), is deposited on top of the second sacrificial layer 310 including the holes 315 by using a PECVD method.

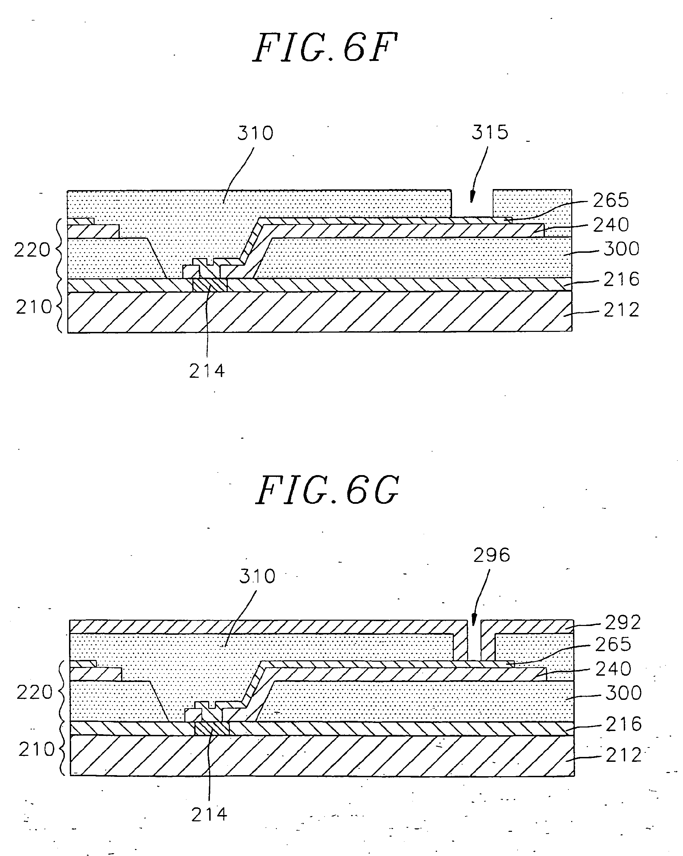

Next, a pair of apertures 296 are formed in the first absorption material 292 to expose the conduction lines 265 of the bridges 240, as shown in Fig. 6G.

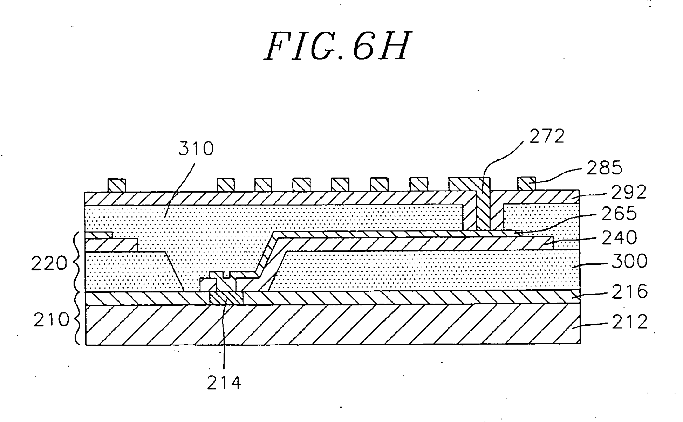

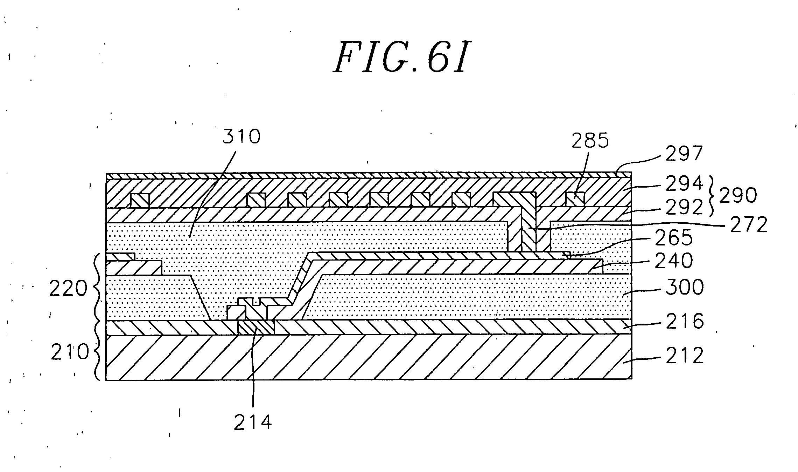

Thereafter, a bolometer element layer (not shown) made of, e.g., titanium (Ti), is deposited on top of the first absorption material 292 including the apertures 296 by using the sputtering method, wherein the apertures 296 are filled with the bolometer element layer, thereby forming a pair of electrical conduits 272. The bolometer element layer is then patterned into a serpentine bolometer element 285 by using the metal etching method, as shown in Fig. 6H.

Subsequently, a second absorption material 2-94 made of the same material as the first absorption material 292 is deposited on top of the serpentine bolometer element 285 to thereby form an absorber 295, as shown in Fig. 6I, wherein the absorber 295 surrounds the serpentine bolometer element 285. Then, the IR absorber coating 297 made of, e.g., titanium (Ti), is deposited on top of the absorber 295 by using the sputtering method so as to have a thickness of the range, e.g., 10-10000nm.

Next, as shown in Fig. 6J, the IR absorber coating 297 is etched by a blanket etching method using Cl₂+O₂ so as to have a predetermined thickness, e.g., 5-9995nm, which, in turn, oxidizes the top surface of the IR absorber coating 297, allowing the IR absorber coating 297 to have a rough top surface. It should be noted that the rough top surface of the IR absorber coating 297 allows the IR absorber coating 297 to efficiently absorb the infrared energy. To be more specific, the IR absorber coating 297 having the rough top surface absorbs more infrared energy than that having a flat top surface, because the rough top surface allows the IR absorber coating 297 to reabsorb a part of the reflected infrared energy.

Subsequently, the IR absorber coating 297 is patterned using a partial etching method to expose a part of the second absorption material 294, as shown in Fig. 6K.

Thereafter, the absorber 295 having the first and the second absorption materials 292, 294 is cellularized into the absorber 295 by using the nitride etching method to thereby form an absorption level 230, as shown in Fig. 6L.

Finally, the second and the first sacrificial layers 310, 300 are removed by using an etching method to thereby form a three-level infrared bolometer 201, as shown in Fig. 6M.

In the three-level infrared bolometer of the present invention, the bridges are positioned under the absorption level allowing the absorption level to be fully utilized for IR absorption, which will, in turn, increase the fill factor thereof, and the infrared absorber coating has the rough surface on the absorber, improving the absorbing efficiency for infrared energy.

While the present invention has been described with respect to certain preferred embodiments only, other modifications and variations may be made without departing from the scope of the present invention as set forth in the following claims.

## Claims

1. A three-level infrared bolometer (201), the bolometer comprising:
an active matrix level (210), the active matrix level including a substrate (212) and at least a pair of connecting terminals (214);
a support level (220) provided with at least a pair of bridges (240), each of the bridges including a conduction line (265), one end of the conduction line being electrically connected to the respective connecting terminal;
an absorption level (230), the absorption level including an absorber (295), a bolometer element (285) surrounded by the absorber, and an infrared absorber coating (297) formed on top of the absorber and having a rough surface; and
at least a pair of posts (270), each of the posts being placed between the absorption level (230) and the support level (220) and including an electrical conduit (272) surrounded by an insulating material, each end of the bolometer element (285) of the absorption level being electrically connected to the respective connecting terminal through the respective electrical conduit and the respective conduction line.

2. The bolometer of claim 1, wherein each of the bridges is provided with an anchor portion (242), a leg portion (244) and an elevated portion (246), the anchor portion including a via hole through which one end of the conduction line is electrically connected to the connecting terminal.

3. The bolometer of claim 1, wherein the conduction line is positioned on top of the bridges.

4. The bolometer of claim 1, wherein the infrared absorber coating is made of titanium.

5. The bolometer of claim 1, wherein top end of the electrical conduit is electrically connected to one end of the bolometer element and bottom end of the electrical conduit is electrically connected to the other end of the conduction line.

6. The bolometer of claim 1, wherein the conduction line, the electrical conduit and the bolometer element are made of the same metal.

7. The bolometer of claim 6, wherein the conduction line, the electrical conduit and the bolometer element are made of titanium.

8. A method for the manufacture of a three-level infrared bolometer, the method comprising the step of:
preparing an active matrix level including a substrate and a pair of connecting terminals;
forming a first sacrificial layer including a pair of cavities on top of the active matrix level;
forming a support level including a pair of bridges, wherein each of the bridges includes a conduction line formed thereon;
forming a second sacrificial layer including a pair of holes on top of the bridges and the first sacrificial layer;
depositing a first absorption material on top of the second sacrificial layer including the holes;
forming a pair of apertures in the first absorption material to expose the conduction lines of the bridges;
depositing a bolometer element layer on top of the first absorption material including the apertures, the apertures being filled with the bolometer element layer;
depositing a second absorption material to form an absorber to surround the bolometer;
depositing an infrared absorber coating on top of the absorber;
etching the infrared absorber coating so as to have a rough top surface; and
removing the second and the first sacrificial layers, respectively, to thereby form said three-level infrared bolometer.

9. The method of claim 8, wherein the etching process of the infrared absorber coating is carried out by a blanket etching method using Cl₂+O₂.

10. The method of claim 8, wherein the infrared absorber coating is deposited by a sputtering method so as to have a predetermined thickness.

11. The method of claim 10, wherein the infrared absorber coating is partially etched so as to have a predetermined thickness.

12. The method of claim 8, wherein the first sacrificial layer is formed by: depositing a first sacrificial material on top of the active matrix level; and removing the first sacrificial material, selectively, to form the first sacrificial layer including the pair of cavities.

13. The method of claim 8, wherein the support level is formed by: depositing a support layer on top of the first sacrificial layer including the cavities; forming a pair of via holes in the support-layer to expose the connecting terminals; forming the pair of conduction line on top of the support layer including the via holes; and patterning the support layer into the pair of bridges, respectively, wherein each of the conduction line is positioned on top of the bridges.

14. The method of claim 8, wherein the second sacrificial layer is formed by: depositing a second sacrificial material on top of the bridges and the first sacrificial layer; and removing the second sacrificial material, selectively.

## Patentansprüche

1. Ein Infrarotbolometer (201) mit drei Niveaus, wobei das Bolometer umfaßt:
ein Aktivmatrixniveau (210), wobei das Aktivmatrixniveau ein Substrat (212) und wenigstens ein Paar Verbindungsanschlüsse (214) aufweist;
ein Trägerniveau (220), das mit wenigstens einem Paar Brücken (240) versehen ist, wobei jede der Brücken eine Leitung (265) aufweist, wobei ein Ende der Leitung elektrisch verbunden ist mit dem jeweiligen Verbindungsanschluß,
ein Absorptionsniveau (230), wobei das Absorptionsniveau einen Absorber (295) aufweist, ein bolometrisches Element (285), das von dem Absorber umgeben ist und eine Infrarotabsorptionsschicht (297), die auf dem Absorber ausgebildet ist und eine rauhe Oberfläche hat; und
wenigstens ein Paar Stützen (270), wobei jede der Stützen zwischen dem Absorptionsniveau (230) und dem Trägerniveau (220) angeordnet ist und einen elektrischen Leiter (272) aufweist, der von einem isolierenden Material umgeben ist, wobei jedes Ende des bolometrischen Elements (285) des Absorptionsniveaus elektrisch mit dem jeweiligen Verbindungsanschluß über den entsprechenden elektrischen Leiter und die entsprechende Leitung verbunden ist.

2. Bolometer nach Anspruch 1, bei welchem jede der Brücken mit einem Verankerungsabschnitt (242), einem Schenkelabschnitt (244) und einem erhabenen Abschnitt (246) versehen ist, wobei der Verankerungsabschnitt ein Durchgangsloch aufweist, durch das ein Ende der Leitung elektrisch mit dem Verbindungsanschluß verbunden ist.

3. Bolometer nach Anspruch 1, bei welchem die Leitung oben auf den Brücken angeordnet ist.

4. Bolometer nach Anspruch 1, bei welchem die Infrarotabsorberschicht aus Titan hergestellt ist.

5. Bolometer nach Anspruch 1, bei welchem das obere Ende des elektrischen Leiters elektrisch mit einem Ende des bolometrischen Elements verbunden ist und das untere Ende des elektrischen Leiters elektrisch mit dem anderen Ende der Leitung verbunden ist.

6. Bolometer nach Anspruch 1, bei welchem die Leitung, der elektrische Leiter und das bolometrische Element aus demselben Metall hergestellt sind.

7. Bolometer nach Anspruch 6, bei welchem die Leitung, der elektrische Leiter und das bolometrische Element aus Titan hergestellt sind.

8. Verfahren zur Herstellung eines Infrarotbolometers mit drei Niveaus, wobei das Verfahren den Schritt aufweist:
Zubereiten eines Aktivmatrixniveaus, einschließlich eines Substrats und eines Paars Verbindungsanschlüsse;
Ausbilden einer ersten Opferschicht einschließlich eines Paars Kavitäten, oben auf dem Aktivmatrixniveau;
Ausbilden eines Trägerniveaus, einschließlich eines Paars Brücken, wobei jede der Brücken eine daran ausgebildete Leitung aufweist;
Ausbilden einer zweiten Opferschicht einschließlich eines Paars Löcher oben auf den Brücken und die erste Opferschicht;
Abscheiden eines ersten Absorptionsmaterials oben auf der zweiten Opferschicht, einschließlich der Löcher;
Ausbilden eines Paares von Öffnungen in dem ersten Absorptionsmaterial zum Freilegen der Leitungen der Brücken;
Abscheiden einer Schicht eines bolometrischen Elements oben auf dem ersten Absorptionsmaterial, einschließlich die Öffnungen, wobei die Öffnungen von der Schicht des bolometrischen Elements gefüllt werden;
Abscheiden eines zweiten Absorptionsmaterials, um einen Absorber zum Umgeben des Bolometers auszubilden;
Abscheiden einer Infrarotabsorberschicht oben auf dem Absorber;
Ätzen der Infrarotabsorberschicht, um eine rauhe obere Oberfläche zu erlangen; und
Entfernen der zweiten bzw. der ersten Opferschicht, um dabei das Infrarotbolometer mit drei Niveaus auszubilden.

9. Verfahren nach Anspruch 8, bei welchem der Ätzprozeß für die Infrarotabsorberschicht durchgeführt wird durch ein Schutzgasätzverfahren unter Verwendung von Cl₂ + O₂.

10. Verfahren nach Anspruch 8, bei welchem die Infrarotabsorberschicht abgeschieden wird über ein Sputterverfahren, um eine vorbestimmte Dicke zu haben.

11. Verfahren nach Anspruch 10, bei welchem die Infrarotabsorberschicht teilweise geätzt wird, um eine vorbestimmte Dicke zu haben.

12. Verfahren nach Anspruch 8, bei welchem die erste Opferschicht ausgebildet wird durch: Abscheiden eines ersten Opfermaterials oben auf dem Aktivmatrixniveau; und selektives Entfernen des ersten Opfermaterials, um die erste Opferschicht, einschließlich des Paares an Kavitäten, auszubilden.

13. Verfahren nach Anspruch 8, bei welchem das Trägerniveau ausgebildet wird durch: Abscheiden einer Trägerschicht oben auf der ersten Opferschicht, einschließlich den Kavitäten; Ausbilden eines Paares Durchgangslöcher in der Trägerschicht, um die Verbindungsanschlüsse freizulegen; Ausbilden des Paares an Leitungen oben auf der Trägerschicht, einschließlich der Durchgangslöcher; und Strukturieren der Trägerschicht zu einem jeweiligen Paar Brücken, wobei jede der Leitungen oben auf den Brücken angeordnet ist.

14. Verfahren nach Anspruch 8, bei welchem die zweite Opferschicht ausgebildet wird durch: Abscheiden eines zweiten Opfermaterials oben auf den Brücken und der ersten Opferschicht; und ein selektives Entfernen des zweiten Opfermaterials.

## Revendications

1. Bolomètre à infrarouges à trois niveaux (201), le bolomètre comprenant:
• un niveau de matrice active (210), le niveau de matrice active comprenant un substrat (212) et au moins une paire de bornes de connexion (214) ;
• un niveau de support (220) muni d'au moins une paire de ponts (240), chacun des ponts comprenant une ligne de conduction (265), une extrémité de la ligne de conduction étant électriquement connectée à la borne de connexion respective ;
• un niveau d'absorption (230), le niveau d'absorption comprenant un absorbeur (295), un élément de bolomètre (285) entouré par l'absorbeur, et un revêtement de l'absorbeur d'infrarouges (297) formé sur le dessus de l'absorbeur et ayant une surface rugueuse ; et
• au moins une paire de montants (270), chacun des montants étant placé entre le niveau d'absorption (230) et le niveau de support (220) et comprenant un conduit électrique (272) entouré par un matériau isolant, chaque extrémité de l'élément de bolomètre (285) du niveau d'absorption étant électriquement connectée à la borne de connexion respective par l'intermédiaire du conduit électrique respectif et de la ligne de conduction respective.

2. Bolomètre selon la revendication 1, dans lequel chacun des ponts est muni d'une partie d'ancrage (242), d'une partie de jambe (244) et d'une partie surélevée (246), la partie d'ancrage comprenant un trou d'interconnexion à travers lequel une extrémité de la ligne de conduction est électriquement connectée à la borne de connexion.

3. Bolomètre selon la revendication 1, dans lequel la ligne de conduction est positionnée sur le dessus des ponts.

4. Bolomètre selon la revendication 1, dans lequel le revêtement de l'absorbeur d'infrarouges est composé de titane.

5. Bolomètre selon la revendication 1, dans lequel l'extrémité supérieure du conduit électrique est électriquement connectée à une extrémité de l'élément de bolomètre et l'extrémité inférieure du conduit électrique est électriquement connectée à l'autre extrémité de la ligne de conduction.

6. Bolomètre selon la revendication 1, dans lequel la ligne de conduction, le conduit électrique et l'élément de bolomètre sont composés du même métal.

7. Bolomètre selon la revendication 6, dans lequel la ligne de conduction, le conduit électrique et l'élément de bolomètre sont composés de titane.

8. Procédé pour la fabrication d'un bolomètre à infrarouges à trois niveaux, le procédé comprenant l'étape consistant à :
• préparer un niveau de matrice active comprenant un substrat et une paire de bornes de connexion ;
• former une première couche sacrificielle comprenant une paire de cavités sur le dessus du niveau de matrice active ;
• former un niveau de support comprenant une paire de ponts, chacun des ponts comprenant, formée sur lui, une ligne de conduction ;
• former une seconde couche sacrificielle comprenant une paire de trous sur le dessus des ponts et de la première couche sacrificielle ;
• déposer un premier matériau d'absorption sur le dessus de la seconde couche sacrificielle comprenant les trous ;
• former une paire d'ouvertures dans le premier matériau d'absorption pour exposer les lignes de conduction des ponts ;
• déposer une couche d'élément de bolomètre sur le dessus du premier matériau d'absorption comprenant les ouvertures, les ouvertures étant remplies avec la couche d'élément de bolomètre ;
• déposer un second matériau d'absorption pour former un absorbeur pour entourer le bolomètre;
• déposer un revêtement de l' absorbeur d'infrarouges sur le dessus de l'absorbeur;
• graver le revêtement de l'absorbeur d'infrarouges de manière à avoir une surface supérieure rugueuse ; et
• retirer les seconde et première couches sacrificielles, respectivement, pour former ainsi ledit bolomètre à infrarouges à trois niveaux.

9. Procédé selon la revendication 8, dans lequel le processus de gravure du revêtement de l'absorbeur d'infrarouges est effectué par un procédé de gravure de couche utilisant du Cl₂+O₂.

10. Procédé selon la revendication 8, dans lequel le revêtement de l'absorbeur d'infrarouges est déposé par un procédé de pulvérisation de manière à avoir une épaisseur prédéterminée.

11. Procédé selon la revendication 10, dans lequel le revêtement de l'absorbeur d'infrarouges est partiellement gravé de manière à avoir une épaisseur prédéterminée.

12. Procédé selon la revendication 8, dans lequel la première couche sacrificielle est formée en : déposant un premier matériau sacrificiel sur le dessus du niveau de matrice active ; et retirant le premier matériau sacrificiel, sélectivement, pour former la première couche sacrificielle comprenant la paire de cavités.

13. Procédé selon la revendication 8, dans lequel le niveau de support est formé en: déposant une couche de support sur le dessus de la première couche sacrificielle comprenant les cavités; formant une paire de trous d'interconnexion dans la couche de support pour exposer les bornes de connexion ; formant la paire de lignes de conduction sur le dessus de la couche de support comprenant les trous d'interconnexion ; et modelant la couche de support en la paire de ponts, respectivement, chacune des lignes de conduction étant positionnée sur le dessus des ponts.

14. Procédé selon la revendication 8, dans lequel la seconde couche sacrificielle est formée en : déposant un second matériau sacrificiel sur le dessus des ponts et de la première couche sacrificielle; et retirant le second matériau sacrificiel, sélectivement.
